# EUROPÄISCHE PATENTSCHRIFT

(11) **EP 0 744 772 B1**
(45) Veröffentlichungstag und Bekanntmachung des Hinweises auf die Patenterteilung: **14.08.2002**
(21) Anmeldenummer: 96107434.1
(22) Anmeldetag: 10.05.1996
(51) Int. Cl.: H01L 27/108, H01L 21/8242

(54) **DRAM-Speicherzelle mit vertikalem Transistor und Verfahren zur Herstellung derselben**
DRAM storage cell with vertical transistor and method for production thereof
Cellule de stockage DRAM à transistor vertical et son procédé de fabrication

(30) Priorität: 24.05.1995 DE 19519159
(43) Veröffentlichungstag der Anmeldung: 27.11.1996
(73) Patentinhaber: Infineon Technologies AG, 81669 München (DE)
(72) Erfinder: Rösner, Wolfgang, Dr., 81739 München (DE); Risch, Lothar, Dr., 85579 Neubiberg (DE); Hofmann, Franz, Dr., 80995 München (DE); Krautschneider, Wolfgang, Dr., 83104 Hohenthann (DE)
(74) Vertreter: Reinhard - Skuhra - Weise & Partner

(56) Entgegenhaltungen:
- EP-A- 0 175 433
- US-A- 4 974 060
- US-A- 5 376 575
- PATENT ABSTRACTS OF JAPAN vol. 17, no. 401 (E-1404), 27.Juli 1993 & JP-A-05 075059 (MITSUBISHI ELECTRIC CORP), 26.März 1993,
- PATENT ABSTRACTS OF JAPAN vol. 14, no. 156 (E-908), 26.März 1990 & JP-A-02 014563 (MATSUSHITA ELECTRON CORP), 18.Januar 1990,
- INTERNATIONAL ELECTRON DEVICES MEETING 1991, Bd. 17, Nr. 2.1, 8. - 11.Dezember 1991, WASHINGTON, DC, USA, Seiten 469-472, XP000342180 T. OZAKI ET AL.: "A Surrounding Isolation-Merged Plate Electrode (SIMPLE) Cell with checkered layout for 256Mbit DRAM and beyond"
- PATENT ABSTRACTS OF JAPAN vol. 16, no. 59 (E-1166), 14.Februar 1992 & JP-A-03 256358 (HITACHI LTD), 15.November 1991,

## Beschreibung

Aus der US-A-5,376,575 ist ein Verfahren zur Herstellung eines DRAM-Speichers mit einem vertikalen Transistor bekannt. Bei der bekannten Speicherzellenanordnung sind in streifenförmigen Gräben vergrabene Bitleitungen vorgesehen. An die Gräben angrenzend ist ein Source-/Drain-Gebiet vorgesehen, das durch Ausdiffusion aus der Bitleitung gebildet wird. Oberhalb der Bitleitung ist durch eine Isolationsstruktur getrennt eine Gateelektrode des vertikalen Transistors angeordnet, welcher entlang einer Flanke des Grabens gebildet ist. An der oberen Ecke der Grabenflanke ist ein zweites Source/Drain-Gebiet angeordnet, welches durch Ausdiffusion einer Diffusionsquelle erzeugt wird.

In DRAM-Zellenanordnungen, das heißt, Speicherzellenanordnungen mit dynamischen, wahlfreiem Zugriff, werden fast ausschließlich sogenannte Eintransistor-Speicherzellen eingesetzt. Eine Eintransistorspeicherzelle umfaßt einen Auslesetransistor und einen Speicherkondensator. In dem Speicherkondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden.

Da von Speichergeneration zu Speichergeneration die Speicherdichte zunimmt, muß die benötigte Fläche der Eintransistorspeicherzelle von Generation zu Generation reduziert werden. Da der Reduktion der Strukturgrößen durch die minimale in der jeweiligen Technologie herstellbare Strukturgröße F Grenzen gesetzt sind, ist dies auch mit einer Veränderung der Eintransistorspeicherzelle verbunden. So wurden bis zur 1MBit-Generation sowohl der Auslesetransistor als auch der Speicherkondensator als planare Bauelemente realisiert. Ab der 4MBit-Speichergeneration mußte eine weitere Flächenreduzierung durch eine dreidimensionale Anordnung von Auslesetransistor und Speicherkondensator erfolgen. Eine Möglichkeit besteht darin, den Speicherkondensator in einem Graben zu realisieren (siehe zum Beispiel Yamada, K. et al, A deep trenched capacitor technology for 4Mbit DRAMs Proc. Intern. Electronic Devices & Materials IEDM 85, p. 702).

Ferner ist vorgeschlagen worden (siehe zum Beispiel Kawamoto, Y. et al, A 1,28 µm² Shielded Memory Cell Technology for 64Mbit DRAMs, Techn. Digest of VLSI Symposium, 1990, p. 13), den Speicherkondensator als Stapelkondensator, den sogenannten stacked capacitor, auszuführen. Dabei wird über den Wortleitungen eine Struktur aus Polysilizium, zum Beispiel eine Kronenstruktur oder ein Zylinder gebildet, der mit dem Substrat kontaktiert wird. Diese Polysiliziumstruktur bildet den Speicherknoten. Er wird mit Kondensatordielektrikum und Kondensatorplatte versehen. Dieses Konzept hat den Vorzug, daß es weitgehend mit einem Logikprozeß kompatibel ist.

Die Fläche für eine Speicherzelle eines DRAM in der 1GBit-Generation soll nur etwa 0,2 µm² betragen. Der Speicherkondensator muß dabei eine Kapazität von 20 bis 30 fF aufweisen. Eine derartige Kapazität ist bei einer Zellfläche, wie sie bei der 1GBit-Generation zur Verfügung steht, in einem Stapelkondensator nur mit einer relativ komplizierten Struktur der Polysiliziumstruktur machbar. Diese komplizierten Strukturen sind zusätzlich durch ihre Topologie immer schwieriger herstellbar.

Ferner ist vorgeschlagen worden, die pro Fläche erzielbare Kapazität durch Verwendung eines Dielektrikum mit einer hohen Dielektrizitätskonstante zu erhöhen. Als Dielektrikum mit hoher Dielektrizitätskonstante sind insbesondere Para- und Ferroelektrika geeignet (siehe zum Beispiel WO 93/12542).

In US 4 974 060 ist eine DRAM-Anordnung vorgeschlagen worden, in der je Speicherzelle ein MOS-Transistor und ein Kondensator entlang einer Siliziumsäule angeordnet sind. Benachbarte Siliziumsäulen sind durch Isolationsstrukturen gegeneinander isoliert. Jede Siliziumsäule ist an der Kreuzung zwischen einer Bitleitung und einer Wortleitung angeordnet. Die Bitleitungen sind dabei an der Oberfläche der Isolationsstrukturen angeordnet und umgeben die Siliziumsäule ringförmig. Die Bitleitungen sind ihrerseits mit einer weiteren Isolationsstruktur bedeckt. An der Oberfläche der weiteren Isolationsstruktur sind die Wortleitungen angeordnet, die die Bitleitungen kreuzen und die die jeweilige Siliziumsäule ringförmig umgeben. Im oberen Bereich der Siliziumsäule ist der Kondensator angeordnet.

Der Erfindung liegt das Problem zugrunde, eine DRAM-Zellenanordnung anzugeben, die als Speicherzellen Eintransistorspeicherzellen umfaßt und die in der für die 1GBit-Generation erforderlichen Packungsdichte herstellbar ist. Ferner soll ein Herstellverfahren für eine solche DRAM-Zellenanordnung angegeben werden.

Dieses Problem wird gelöst durch eine DRAM-Zellenanordnung gemäß Anspruch 1 sowie ein Verfahren zu deren Herstellung gemäß Anspruch 7. Weitere Ausgestaltungen der Erfindung gehen aus den übrigen Ansprüchen hervor.

In der erfindungsgemäßen DRAM-Zellenanordnung sind Eintransistorspeicherzellen vorgesehen, in denen der Auslesetransistor als vertikaler MOS-Transistor ausgebildet ist. Dabei grenzt eines der Source/Drain-Gebiete des vertikalen MOS-Transistors an eine Hauptfläche eines Halbleitersubstrats, in dem die DRAM-Zellenanordnung realisiert ist, an. Das andere Source/Drain-Gebiet grenzt an eine vergrabene Bitleitung an. Auf der Hauptfläche ist an der Oberfläche des dort angrenzenden Source/Drain-Gebietes ein Kondensatordielektrikum und darüber eine Zellplatte angeordnet. Das an die Hauptfläche angrenzende Source/Drain-Gebiet wird zusätzlich als Speicherknoten für den aus Kondensatorplatte, Kondensatordielektrikum und Source/Drain-Gebiet gebildeten Speicherkondensator.

Das Kanalgebiet des MOS-Transistors ist im Halbleitersubstrat angeordnet und mit einem Gatedielektrikum und einer Gateelektrode versehen. Die Gateelektrode ist mit einer Wortleitung verbunden. Gateelektroden und Wortleitungen sind im Substrat vergraben und durch Isolationsstrukturen gegenüber den Source/Drain-Gebieten, den Bitleitungen und den Kanalgebieten isoliert.

Die DRAM-Zellenanordnung wird vorzugsweise in einem Halbleitersubstrat realisiert, das mindestens in dem Bereich für die DRAM-Zellenanordnung monokristallines Silizium umfaßt. Das kann sowohl eine Scheibe durchgehend aus monokristallinem Silizium als auch ein SOI-Substrat, das auf eine Siliziumscheibe eine isolierende Schicht und darauf eine dünne monokristalline Siliziumschicht umfaßt, sein.

Vorzugsweise wird das Kondensatordielektrikum aus einem Material mit einer relativen Dielektrizitätskonstante εᵣ zwischen 100 und 1000 gebildet.

Die erfindungsgemäße DRAM-Zellenanordnung kann mit einer planaren Oberfläche oder mit einer Oberfläche mit einer flachen Topologie hergestellt werden, so daß als Kondensatordielektrikum eine ferroelektrische oder paraelektrische Schicht verwendet werden kann. Ferroelektrische und paraelektrische Schichten weisen eine hohe relative Dielektrizitätskonstante εᵣ im Bereich von 500 bis 1000 auf. Wenn diese Schichten durch Sputtern abgeschieden werden, sind sie nur auf ebenen Oberflächen oder Oberflächen mit einer flachen Topologie einsetzbar. Auch bei CVD- oder Sol-Gel-Verfahren mit besserer Kantenbedeckung können durch die benötigte Dicke der Schichten keine komplizierten 3D-Strukturen hergestellt werden. Als Kondensatordielektrikum wird vorzugsweise Barium-Strontium-Titanat, Blei-Zirkon-Titanat, Y1, oder Strontium-Titanat verwendet. Mit diesen Dielektrika mit hoher relativer Dielektrizitätskonstante kann die erforderliche Kapazität in 20 bis 30 fF auch auf einer Fläche von etwa 0,2 bis 0,4 µm² erzielt werden.

Das Halbleitersubstrat weist in Reihen und Spalten angeordnete Säulen aus Halbleitermaterial auf. Die vertikalen MOS-Transistoren werden entlang mindestens einer Flanke dieser Säulen so realisiert, daß Gatedielektrikum und Gateelektrode die Flanke der jeweiligen Säule parallel zur Hauptfläche des Halbleitersubstrats nur teilweise bedecken. Besonders vorteilhaft herstellbar sind die vertikalen MOS-Transistoren, wenn sie zwei aneinandergrenzende Flanken der Säulen jeweils teilweise bedecken.

Die Bitleitungen verlaufen jeweils zwischen benachbarten Reihen von Säulen. Zwischen benachbarten Spalten von Säulen verlaufen die Wortleitungen, die jeweils mit Gateelektroden verbunden sind. Zwischen den Wortleitungen und den Bitleitungen ist eine Isolationsstruktur vorgesehen. Die Wortleitungen sind darüber hinaus gegenüber den aktiven Transistorgebieten isoliert.

Die Säulen werden vorzugsweise durch zwei Ätzschritte hergestellt. Dabei werden zunächst erste Gräben geätzt, die im wesentlichen parallel verlaufen. Im zweiten Ätzschritt werden zweite Gräben geätzt, die die ersten Gräben kreuzen und ebenfalls im wesentlichen parallel verlaufen. Werden die ersten Gräben und die zweiten Gräben so dimensioniert, daß die Breite jedes Grabens gleich dem Abstand zwischen benachbarten Gräben ist und wird diese Breite entsprechend der in der jeweiligen Technologie kleinsten herstellbaren Strukturgröße F gewählt, so beträgt die Fläche für eine Speicherzelle 4 F². Das heißt, in einer 0,18 µm -Technologie benötigt jede Speicherzelle eine Fläche von 0,13 µm².

Im folgenden wird die Erfindung anhand der Figuren und eines Ausführungsbeispiels näher erläutert.
- Figur 1: zeigt einen Schnitt durch ein Substrat nach der Bildung von ersten Gräben und Bitleitungen.
- Figur 2: zeigt einen Schnitt parallel zum Verlauf der Bitleitungen durch das Substrat nach der Bildung zweiter Gräben.
- Figur 3: zeigt einen Schnitt parallel zu einer Bitleitung zwischen benachbarten Bitleitungen durch das Substrat nach der Ätzung von Öffnungen für vertikale MOS-Transistoren.
- Figur 4: zeigt einen Schnitt senkrecht zu den Bitleitungen durch das Substrat nach der Öffnung der Löcher zur Bildung der vertikalen MOS-Transistoren.
- Figur 5: zeigt einen Schnitt senkrecht zu den Bitleitungen durch das Substrat nach der Bildung von Gateoxid, Gateelektrode, Kondensatordielektrikum und Kondensatorplatte.
- Figur 6: zeigt einen Schnitt senkrecht zu den Bitleitungen, parallel zu den Wortleitungen durch eine Wortleitung durch das Substrat nach der Bildung von Gateoxid, Gateelektrode, Wortleitungen, Kondensatordielektrikum und Kondensatorplatte.
- Figur 7: zeigt eine schematische Aufsicht auf ein Substrat mit den ersten Gräben und den zweiten Gräben und den Maskenöffnungen zur Bildung der Löcher für die vertikalen MOS-Transistoren.

In einer Hauptfläche 1 eines Substrates 2 aus zum Beispiel monokristallinem Silizium, das mindestens im Bereich für eine DRAM-Zellenanordnung p-dotiert mit einer Dotierstoffkonzentration von zum Beispiel 5 x 10¹⁷ cm⁻³ ist, wird ganzflächig ein n⁺-dotiertes Gebiet 3 erzeugt. Das n+-dotierte Gebiet 3 wird zum Beispiel durch Ionenimplantation gebildet. Es weist eine Dotierstoffkonzentration von zum Beispiel 1 x 10²⁰ cm⁻³ auf. Die Tiefe des n⁺-dotierten Gebietes beträgt zum Beispiel 0,5 µm.

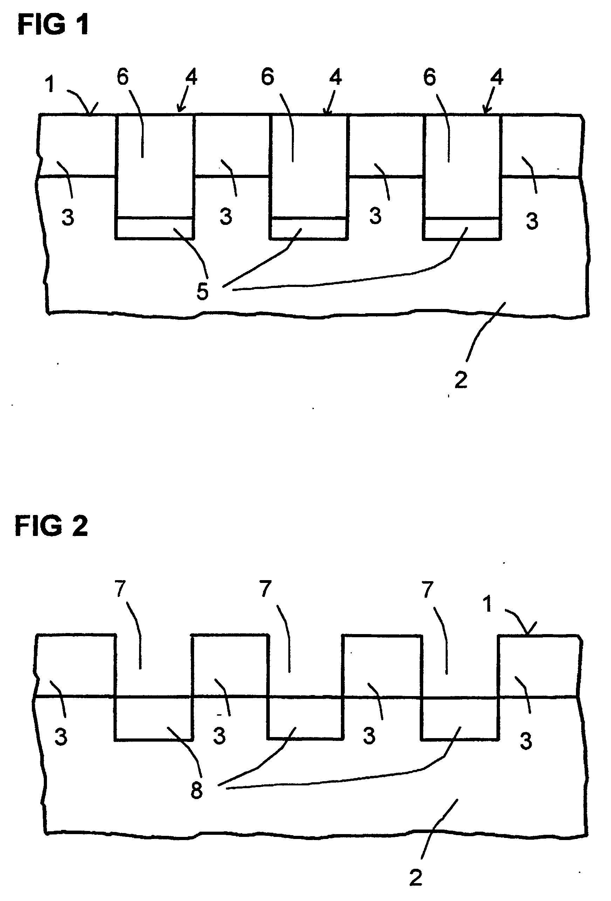

Unter Verwendung einer Grabenmaske aus zum Beispiel SiO₂ und Photolack (nicht dargestellt) werden in der Hauptfläche 1 erste Gräben 4 geätzt. Die ersten Gräben 4 verlaufen im wesentlichen parallel. Sie weisen eine Tiefe von zum Beispiel 0,8 µm auf. Die Weite der ersten Gräben 4 beträgt zum Beispiel F = 180 nm, der Abstand zwischen benachbarten Gräben 4 beträgt zum Beispiel F = 180 nm. Die ersten Gräben 4 erstrecken sich parallel zur Hauptfläche 1 über das gesamte Zellenfeld und weisen eine Länge von zum Beispiel 100 µm auf. Die Tiefe der ersten Gräben 4 muß mindestens so hoch sein, daß die ersten Gräben 4 durch das n⁺-dotierte Gebiet 3 hindurchreichen (siehe Figur 1).

Durch Ionenimplantation werden am Boden der ersten Gräben 4 n⁺-dotierte Bitleitungen 5 gebildet. Die Bitleitungen 5 weisen eine Dotierstoffkonzentration von zum Beispiel mindestens≥ 10²⁰ cm⁻³ und eine Tiefe von zum Beispiel 0,2 µm auf.

Die ersten Gräben 4 werden anschließend mit einer ersten Isolationsstruktur 6 aus zum Beispiel SiO₂ aufgefüllt. Die erste Isolationsstruktur 6 wird zum Beispiel durch konforme Abscheidung einer SiO₂-Schicht und anschließende Planarisierung gebildet.

Anschließend werden unter Verwendung einer zweiten Grabenmaske zweite Gräben 7 geätzt, die die ersten Gräben 4 im wesentlichen im rechten Winkel kreuzen. Die zweiten Gräben 7 werden in derselben Tiefe wie die ersten Gräben 4 geätzt. Es ist wesentlich, daß die Oberfläche der Bitleitungen in den zweiten Gräben 7 freigelegt wird. Anschließend werden die zweiten Gräben 7 mit zweiten Isolationsstrukturen 8 aufgefüllt. Die zweiten Isolationsstrukturen 8 reichen in etwa bis zu der Höhe der n⁺-dotierten Gebiete 3. Die zweiten Isolationsstrukturen 8 werden zum Beispiel aus SiO₂ durch konforme Abscheidung einer SiO₂-Schicht und anschließendes Rückätzen gebildet (siehe Figur 2, in der ein Schnitt senkrecht zu dem in Figur 1 dargestellten Schnitt, parallel zu einer Bitleitung 5, zwischen zwei benachbarten Bitleitungen 5 darstellt).

Je zwei Paare benachbarter erster Gräben 4 sowie zweiter Gräben 7 definieren eine Säule aus Silizium, die im Bereich der Hauptfläche 1 das n⁺-dotierte Gebiet 3 und darunter Substratmaterial 2, das p-dotiert ist, aufweist.

Es wird eine Maske 9 aus zum Beispiel SiO₂ erzeugt, die Maskenöffnungen 10 aufweist. Die Maskenöffnungen 10 weisen einen parallel zur Hauptfläche 1 im wesentlichen quadratischen Querschnitt auf und sind rasterförmig angeordnet. Durch die Maskenöffnungen 10 wird die Anordnung von vertikalen MOS-Transistoren definiert. Die Maskenöffnungen 10 sind so angeordnet, daß sie jeweils eine Ecke einer der Säulen überlappen. Der quadratische Querschnitt der Maskenöffnungen 10 weist eine Seitenlänge auf, die gleich der Breite der ersten Gräben 4 sowie der zweiten Gräben 7 ist. Die Mitte der Maskenöffnungen 10 ist jeweils um eine halbe Seitenlänge in Bezug auf die Mitten der angrenzenden ersten Gräben 4 und zweiten Gräben 7 versetzt angeordnet. Die Breiten und Abstände der Gräben 4, 7 betragen jeweils eine minimal herstellbare Strukturgröße F, die Seitenlänge der Maskenöffnungen 10 beträgt ebenfalls eine minimal herstellbare Strukturgröße F. Die Mitte der Maskenöffnungen 10 ist bezüglich den Mitten der Gräben 4, 7 jeweils um 1/2 F versetzt. Dabei wird ausgenutzt, daß die Justiergenauigkeit feiner als die kleinste herstellbare Strukturgröße ist. In einer 1 Gbit-Technologie beträgt die kleinste herstellbare Strukturgröße F gleich 180 nm, eine Justierung ist mit einer Genauigkeit von ca. 1/3 F möglich.

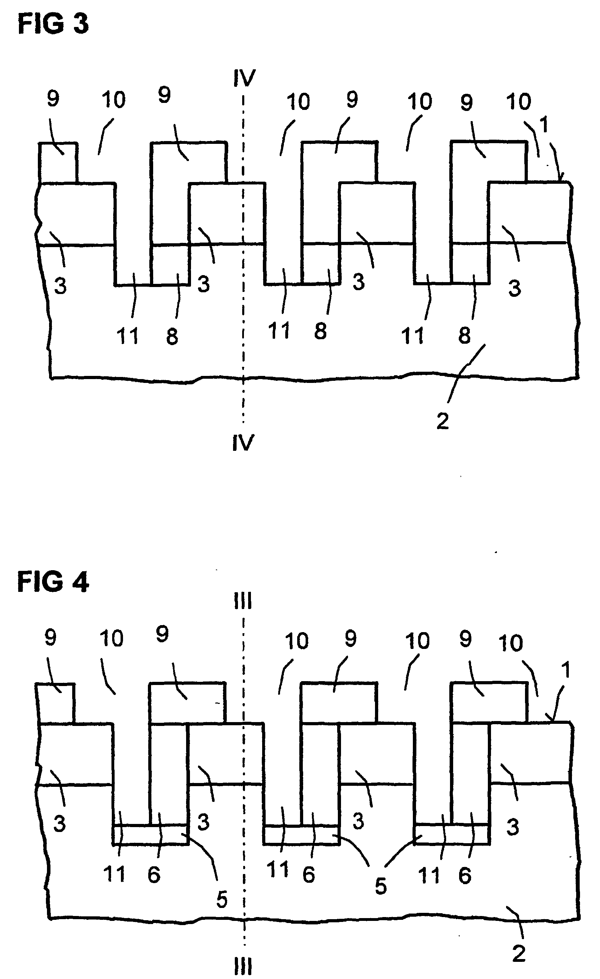

In einem anisotropen Ätzprozeß, der SiO₂ selektiv zu Silizium angreift, zum Beispiel mit reaktivem Ionenätzen, werden Löcher 11 geätzt, die von der Hauptfläche 1 bis auf die Höhe der Bitleitungen 5 reichen (siehe Figur 3 und Figur 4). Die Löcher 11 weisen einen hakenförmigen Querschnitt auf, wobei sich der Haken aus drei kleinen Quadraten zusammensetzen läßt. Das fehlende, vierte kleine Quadrat entsteht durch die Säule aus Silizium, die bei dem anisotropen Ätzprozeß nicht angegriffen wird. Die Flanken der Säule werden in dem Loch 11 freigelegt.

Nach Entfernen der Maske 9 wird zur Bildung eines Gateoxids 12 eine thermische Oxidation bei zum Beispiel 800°C durchgeführt. Dabei entsteht an allen freiliegenden Siliziumoberflächen SiO₂. Anschließend werden Gateelektroden 13 und Wortleitungen 14 aus dotiertem Polysilizium erzeugt. Dazu wird zum Beispiel durch in situ dotierte Abscheidung eine Polysiliziumschicht erzeugt, die so dick ist, wie die Löcher 11 und die zweiten Gräben 7 oberhalb der zweiten Isolationsstruktur 8 in der Breite auffüllt. Anschließend wird die dotierte Polysiliziumschicht zum Beispiel durch reaktives Ionenätzen zurückgeätzt, bis die Höhe der Wortleitung 14 unterhalb der Hauptfläche 1 erreicht ist. Die Abmessung der Wortleitungen 14 wird über die Ätzdauer eingestellt. Die Strukturierung der Wortleitungen 14 erfolgt selbstjustiert.

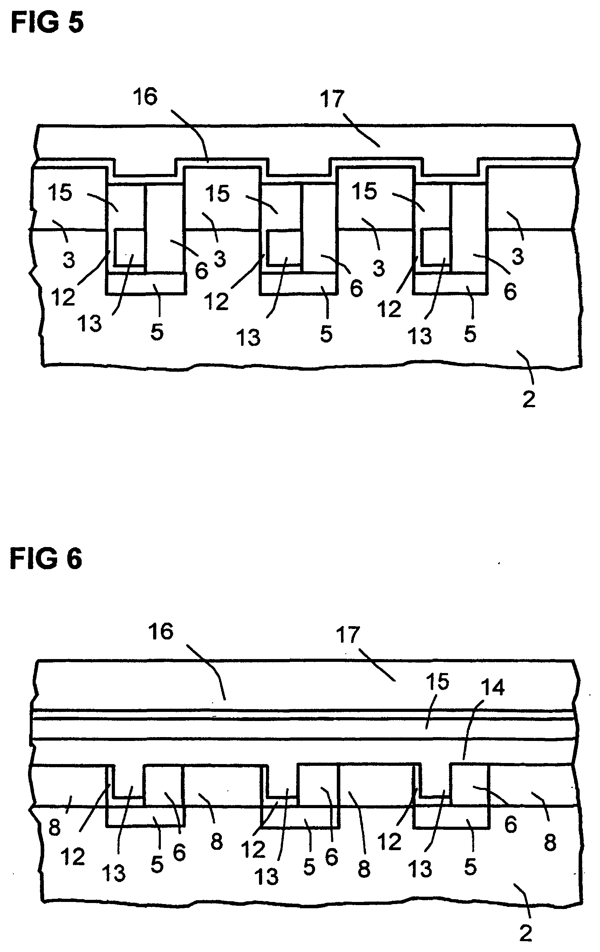

Durch Abscheiden und Rückätzen einer weiteren SiO₂-Schicht werden oberhalb der Wortleitungen dritte Isolationsstrukturen 15 gebildet. Die Höhe der dritten Isolationsstrukturen 15 ist geringer als die Hauptfläche 1, so daß an den Flanken des n⁺-dotierten Gebietes 3 der Säulen jeweils Stufen auftreten (siehe Figur 5 und Figur 6). Die Höhe dieser Stufen beträgt zum Beispiel 0,2 bis 0,5 µm.

Anschließend wird ein Kondensatordielektrikum 16 aufgebracht. Das Kondensatordielektrikum weist eine Dicke von zum Beispiel 50 nm auf. Dazu wird zum Beispiel eine durchgehende ferroelektrische oder paraelektrische Schicht mit einer relativen Dielektrizitätskonstante εᵣ im Bereich zwischen 500 und 1000 durch Sputtern, CVD-Abscheidung oder in einem Sol-Gel-Verfahren aufgebracht. Vorzugsweise umfaßt das Kondensatordielektrikum mindestens einen der Stoffe Barium-Strontium-Titanat, Strontium-Titanat oder Bleizirkontitanat. Das Kondensatordielektrikum 16 ist im Bereich der n⁺-dotierten Gebiete 3 auf der Siliziumoberfläche angeordnet, die beim Rückätzen der dritten Isolationsstrukturen 15 freigelegt wurde. In Fällen, in denen eine Reaktion zwischen dem Material des Kondensatordielektrikums 16 und dem Silizium oder eine Diffusion des Materials des Kondensatordielektrikums 16 in das Silizium oder eine sonstige Beeinträchtigung des Siliziums durch das Material des Kondensatordielektrikums 16 befürchtet werden muß, wird mindestens die freiliegende Oberfläche des n⁺-dotierten Gebietes 3 mit einer Zwischenschicht, zum Beispiel aus TiN, RuO₂, Pt, W, abgedeckt.

Weist das Material des Kondensatordielektrikums 16 Leckströme in einem Ausmaß auf, das für einen Speicherkondensator nicht hinnehmbar ist, so wird das Kondensatordielektrikum 16 strukturiert. Dabei wird das Kondensatordielektrikum 16 jeweils oberhalb der dritten Isolationsstruktur 15 bzw. der ersten Isolationsstruktur 6 unterbrochen.

Auf das Kondensatordielektrikum 16 wird eine durchgehende Kondensatorplatte 17 aus zum Beispiel PolySi, TiN, Pt, W, RuO₂ aufgebracht. Die Kondensatorplatte 17 überdeckt mindestens den Bereich der ersten und zweiten Gräben.

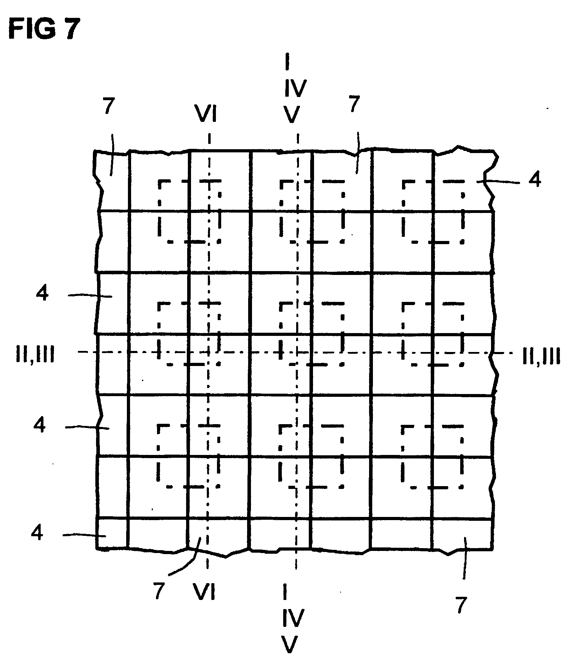

Figur 7 zeigt eine schematische Aufsicht auf das Substrat 2 mit den ersten Gräben 4 und den zweiten Gräben 7. Ferner ist in Figur 7 als strichpunktierte Umrahmung die Lage der Maskenöffnungen 10 angegeben. Zum besseren Verständnis sind ferner durch strichpunktierte Linien mit der Bezeichnung I, II, III, IV, V, VI die Schnitte angedeutet, die in den Figuren 1, 2, 3, 4, 5, 6 dargestellt sind.

Da die ersten Gräben 4 parallel verlaufen und gleiche Breite und gleichen Abstand, zum Beispiel eine minimale Strukturgröße F = 180 nm aufweisen und die zweiten Gräben 7 ebenfalls gleiche Breite und Abstände, zum Beispiel eine minimale Strukturgröße F = 180 nm aufweisen, beträgt der Platzbedarf pro Speicherzelle (2 x Grabenbreite)², zum Beispiel 4 F² = 0,13 µm².

Abgesehen von der möglichen Strukturierung des Kondensatordielektrikums werden zur Herstellung der erfindungsgemäßen DRAM-Zellenanordnung drei zu justierende Masken benötigt. Dabei sind die beiden Masken, die zur Ätzung der ersten Gräben 4 sowie der zweiten Gräben 7 eingesetzt werden, unkritisch bezüglich der Justierung. Lediglich die Maske 9, mit der die Löcher 11 geätzt werden, muß genau justiert werden.

Bei Verwendung eines Materials für das Kondensatordielektrikum 16, das eine ausreichend hohe relative Dielektrizitätskonstante εᵣ aufweist, kann die dritte Isolationsstruktur 15 so gebildet werden, die in der Höhe mit der Hauptfläche 1 abschließt. In der erfindungsgemäßen DRAM-Zellenanordnung bilden n⁺-dotiertes Gebiet 3, Bitleitung 5 sowie dazwischenliegendes Substrat 2 mit dem Gateoxid 12 und der Gateelektrode 13 jeweils einen vertikalen MOS-Transistor. Das n⁺-dotierte Gebiet 3, das Kondensatordielektrikum 16 und die Kondensatorplatte 17 bilden den Speicherkondensator. Das n⁺-dotierte Gebiet 3 wird gleichzeitig als Source/Drain-Gebiet des vertikalen MOS-Transistors und als Speicherknoten des Speicherkondensators verwendet. Dadurch wird ein Platzgewinn erzielt. Darüber hinaus sind Source/Drain-Gebiete des vertikalen MOS-Transistors und Speicherknoten des Speicherkondensators herstellungsgemäß miteinander elektrisch verbunden, so daß die im Stand der Technik zur Verbindung der Polysiliziumstruktur mit dem Substrat bei Stapelkondensatoren erforderliche, kritische Kontaktlochätzung entfällt.

## Patentansprüche

1. DRAM-Zellenanordnung mit Speicherzellen, die jeweils einen Auslesetransistor und einen Speicherkondensator umfassen, welche folgendes aufweist :
- ein Halbleitersubstrat (2), das mindestens im Bereich der DRAM-Zellenanordnung von einem ersten Leitfähigkeitstyp dotiert ist, wobei das Halbleitersubstrat (2) in Reihen und Spalten angeordnete Säulen umfaßt, die an eine Hauptfläche (1) des Halbleitersubstrats (2) angrenzen und die durch erste und zweite Gräben (4, 7) gebildet sind;
- wobei jede Säule ein von einem zweiten, dem ersten entgegengesetzten Leitfähigkeitstyp dotiertes Gebiet (3) und ein vom ersten Leitfähigkeitstyp dotiertes Gebiet (2) aufweist, wobei das vom zweiten Leitfähigkeitstyp dotierte Gebiet (3) jeweils an die Hauptfläche (1) und im Bereich der Hauptfläche (1) an die Flanken der jeweiligen Säule angrenzt und wobei das vom ersten Leitfähigkeitstyp dotierte Gebiet (2) unterhalb des vom zweiten Leitfähigkeitstyp dotierten Gebietes (3) angeordnet ist, an die Flanken der Säule angrenzt und mit dem vom ersten Leitfähigkeitstyp dotierten Bereich des Halbleitersubstrats (2) in Verbindung steht,
- vergrabene Bitleitungen (5), die an den Böden der ersten Gräben (4) angeordnet sind und im wesentlichen parallel zueinander verlaufen;
- wobei die Auslesetransistoren als in den Säulen integrierte, vertikale MOS-Transistoren ausgebildet sind, deren eines Source/Drain-Gebiet das vom zweiten Leitfähigkeitstyp dotierte Gebiet (3) und deren anderes Source/Drain-Gebiet (5) jeweils eine vergrabene Bitleitung (5) ist, deren Gateelektrode (13) jeweils an einer Säulenwand oberhalb eines Gateoxids (12) angeordnet ist;
- vergrabene Wortleitungen (14), die in den zweiten Gräben (7) angeordnet sind und im wesentlichen parallel zueinander verlaufen, die die Bitleitungen (5) isoliert kreuzen und die gegenüber den Säulen isoliert sind, wobei die Gateelektroden (13) jeweils mit einer der Wortleitungen (14) verbunden sind;
- wobei die Speicherkondensatoren jeweils aus einem der an die Hauptfläche (1) angrenzenden, vom zweiten Leitfähigkeitstyp dotierten Gebiete (3) als Speicherknoten, einem darüber angeordneten Kondensatordielektrikum (16) und einer darüber angeordneten Kondensatorplatte (17) aufgebaut sind.

2. DRAM-Zellenanordnung nach Anspruch 1,
bei der das Kondensatordielektrikum (16) aus einem Material mit einer relativen Dielektrizitätskonstante εᵣ zwischen 100 und 1000 gebildet ist.

3. DRAM-Zellenanordnung nach einem der Ansprüche 1 oder 2, bei der das Kondensatordielektrikum (16) als ganzflächige Schicht ausgebildet ist.

4. DRAM-Zellenanordnung nach einem der Ansprüche 1 bis 3, bei der Isolationsstrukturen (6, 15) vorgesehen sind, die den Bereich zwischen benachbarten Säulen nur teilweise auffüllen, so daß im Bereich der Hauptfläche (1) die Flanken der Säulen teilweise mit Kondensatordielektrikum (16) bedeckt sind.

5. DRAM-Zellenanordnung nach einem der Ansprüche 1 bis 4, bei der die Breite der Bitleitungen (5) und der Wortleitungen (14) sowie der Abstand zwischen benachbarten Bitleitungen (5) und zwischen benachbarten Wortleitungen (14) jeweils im wesentlichen gleich ist, und bei der das Gateoxid (12) der vertikalen MOS-Transistoren jeweils zwei aneinander angrenzende Flanken einer Säule teilweise bedeckt, so daß es die jeweilige Wortleitung (14) gegenüber der Säule isoliert.

6. DRAM-Zellenanordnung nach einem der Ansprüche 1 bis 5,
- bei der das Halbleitersubstrat (2) mindestens im Bereich der DRAM-Zellenanordnung monokristallines Silizium umfaßt,
- bei der die Isolationsstrukturen SiO₂ umfassen,
- bei der die Bitleitungen (5) als dotierte Gebiete im Halbleitersubstrat (2) ausgebildet sind,
- bei der die Gateelektroden (13) und die Wortleitungen (14) dotiertes Polysilizium umfassen.

7. Verfahren zur Herstellung einer DRAM-Zellenanordnung nach Anspruch 1,
- bei dem in dem Halbleitersubstrat (2), das mindestens in einem Bereich für die DRAM-Zellenanordnung von einem ersten Leitfähigkeitstyp dotiert ist, innerhalb dieses Bereichs ein von einem zweiten, dem ersten entgegengesetzten Leitfähigkeitstyp dotiertes Gebiet (3) erzeugt wird, das an eine Hauptfläche (1) des Halbleitersubstrats (2) angrenzt,
- bei dem in dem Halbleitersubstrat (2) die im wesentlichen zueinander parallel verlaufenden ersten Gräben (4) erzeugt werden,
- bei dem die Bitleitungen (5) am Boden der ersten Gräben (4) erzeugt werden,
- bei dem anschließend die ersten Gräben (4) mit einer ersten Isolationsstruktur (6) aufgefüllt werden,
- bei dem anschließend die zweiten Gräben (7) erzeugt werden, die die ersten Gräben (4) kreuzen und die mindestens bis auf die Oberfläche der Bitleitung (5) reichen, wobei die Säulen entstehen,
- bei dem die zweiten Gräben (7) mit einer zweiten Isolationsstruktur (8) aufgefüllt werden, deren Höhe geringer ist als die Tiefe der zweiten Gräben (7),
- bei dem eine anisotrope Ätzung durchgeführt wird, die die erste Isolationsstruktur (6) und die zweite Isolationsstruktur (8) selektiv zu den Säulen das Halbleitermaterial angreifen und bei der Löcher (11) geätzt werden, die von der Hauptfläche (1) bis auf die Höhe der Bitleitungen (5) reichen und in denen jeweils eine Flanke der Säulen, die an einen der zweiten Gräben (7) angrenzt, teilweise freigelegt wird,
- bei dem an den freiliegenden Flanken der Säulen Gateoxide (12) erzeugt werden,
- bei dem in den Löchern (11) die Gateelektroden (13) erzeugt werden, die die Löcher (11) jeweils in der Breite ausfüllen,
- bei dem in den zweiten Gräben (7) Wortleitungen (14) erzeugt werden, die jeweils mit entlang dem jeweiligen zweiten Graben (7) angeordneten Gateelektroden (13) elektrisch verbunden sind,
- bei dem in den zweiten Gräben (7) eine dritte Isolationsstruktur (15) erzeugt wird,
- bei dem das Kondensatordielektrikum (16) derart erzeugt wird, daß es mindestens die Oberfläche der Säulen im Bereich der Hauptfläche (1) bedeckt,
- bei dem die Kondensatorplatte (17) derart erzeugt wird, daß sie mindestens die Säulen überdeckt.

8. Verfahren nach Anspruch 7,
- bei dem die ersten Isolationsstrukturen (6) und die dritten Isolationsstrukturen (15) so gebildet werden, daß sie in der Höhe mit den Säulen abschließen,
- bei dem in einem Ätzprozeß selektiv zu den Säulen die ersten Isolationsstrukturen (6) und die dritten Isolationsstrukturen (15) rückgeätzt werden, wobei an den Flanken der Säulen Stufen entstehen, die von dem Kondensatordielektrikum (16) abgedeckt werden.

9. Verfahren nach einem der Ansprüche 7 oder 8,
- bei dem die ersten Gräben (4) und die zweiten Gräben (7) im wesentlichen in gleicher Breite gebildet werden, wobei der Abstand benachbarter Gräben (4, 7) im wesentlichen gleich der Breite der Gräben ist,
- bei dem die Löcher (11) unter Verwendung einer Maske (9) mit im wesentlichen quadratischen Maskenöffnungen (10) geätzt werden, wobei die Seitenlänge der quadratischen Maskenöffnungen (10) im wesentlichen gleich der Breite der Gräben (4, 7) ist,
- bei dem die Mittelpunkte der quadratischen Maskenöffnungen (10) gegenüber den Mitten der ersten Gräben (4) sowie der zweiten Gräben (7) um weniger als eine Breite der Gräben (4, 7) versetzt angeordnet werden.

10. Verfahren nach einem der Ansprüche 7 bis 9,
- bei dem als Halbleitersubstrat (2) ein Substrat verwendet wird, das mindestens im Bereich der DRAM-Zellenanordnung monokristallines Silizium umfaßt,
- bei dem die Isolationsstrukturen (6, 8, 15) aus SiO₂ gebildet werden,
- bei dem die Bitleitungen und das vom zweiten Leitfähigkeitstyp dotierte Gebiet (3) durch Implantation gebildet werden,
- bei dem die Wortleitungen (14) und die Gateelektroden (13) aus dotiertem Polysilizium gebildet werden.

## Claims

1. DRAM cell arrangement having memory cells which each comprise a read-out transistor and a storage capacitor, which arrangement includes the following:
- a semiconductor substrate (2) which, at least in the area of the DRAM cell arrangement, is doped with a first conductivity type, the semiconductor substrate (2) comprising pillars which are arranged in rows and columns, adjoin a main surface (1) of the semiconductor substrate (2) and are formed by first and second trenches (4, 7);
- each column having a region (3) which is doped with a second conductivity type, which is opposite to the first conductivity type, and a region (2) which is doped with the first conductivity type, the region (3) which is doped with the second conductivity type in each case adjoining the main surface (1) and, in the area of the main surface (1), the flanks of the respective pillar, and the region (2) which is doped with the first conductivity type being arranged beneath the region (3) which is doped with the second conductivity type, adjoining the flanks of the pillar and being connected to the area of the semiconductor substrate (2) which is doped with the first conductivity type,
- buried bit lines (5), which are arranged at the bottoms of the first trenches (4) and run substantially parallel to one another;
- the read-out transistors being designed as vertical MOS transistors which are integrated in the pillars and of which one source/drain region is the region (3) which is doped with the second conductivity type and the other source/drain region (5) is in each case a buried bit line (5), the gate electrode (13) of which is in each case arranged on a pillar wall above a gate oxide (12);
- buried word lines (14), which are arranged in the second trenches (7), run substantially parallel to one another, cross the bit lines (5) in an insulated manner and are insulated with respect to the pillars, the gate electrodes (13) in each case being connected to one of the word lines (14);
- the storage capacitors in each case being composed of one of the regions (3) which adjoin the main surface (1) and are doped with the second conductivity type, as storage node, a capacitor dielectric (16) arranged above this region and a capacitor plate (17) arranged above the capacitor dielectric.

2. DRAM cell arrangement according to Claim 1, in which the capacitor dielectric (16) is formed from a material with a relative dielectric constant εᵣ of between 100 and 1000.

3. DRAM cell arrangement according to one of Claims 1 or 2, in which the capacitor dielectric (16) is formed as a layer which covers the entire surface.

4. DRAM cell arrangement according to one of Claims 1 to 3, in which insulation structures (6, 15) are provided, which only partially fill the area between adjacent pillars, so that in the area of the main surface (1) the flanks of the pillars are partially covered with capacitor dielectric (16).

5. DRAM cell arrangement according to one of Claims 1 to 4, in which the width of the bit lines (5) and of the word lines (14) and the distance between adjacent bit lines (5) and between adjacent word lines (14) are in each case substantially identical, and in which the gate oxide (12) of the vertical MOS transistors in each case partially covers two adjacent flanks of a pillar, so that it insulates the respective word line (14) from the pillar.

6. DRAM cell arrangement according to one of Claims 1 to 5,
- in which the semiconductor substrate (2), at least in the area of the DRAM cell arrangement, comprises monocrystalline silicon,
- in which the insulation structures comprise SiO₂,
- in which the bit lines (5) are formed as doped regions in the semiconductor substrate (2),
- in which the gate electrodes (13) and the word lines (14) comprise doped polysilicon.

7. Method for fabricating a DRAM cell arrangement according to Claim 1,
- in which, in the semiconductor substrate (2), which, at least in an area for the DRAM cell arrangement, is doped with a first conductivity type, a region (3) which is doped with a second conductivity type, which is opposite to the first conductivity type, and adjoins a main surface (1) of the semiconductor substrate (2), is produced within this area,
- in which the first trenches (4) which run substantially parallel to one another, are produced in the semiconductor substrate (2),
- in which the bit lines (5) are produced at the bottom of the first trenches (4),
- in which the first trenches (4) are then filled with a first insulation structure (6),
- in which the second trenches (7), which cross the first trenches (4) and extend at least as far as the surface of the bit line (5), are then produced, so that the pillars are formed,
- in which the second trenches (7) are filled with a second insulation structure (8), the height of which is less than the depth of the second trenches (7),
- in which an anisotropic etch is carried out, which attack the first insulation structure (6) and the second insulation structure (8) selectively with respect to the pillars the semiconductor material and during which holes (11) are etched, which extend from the main surface (1) to the level of the bit lines (5) and in which in each case one flank of the pillars, which adjoins one of the second trenches (7), is partially uncovered,
- in which gate oxides (12) are produced on the uncovered flanks of the pillars,
- in which the gate electrodes (13), which in each case fill up the width of the holes (11), are produced in the holes (11),
- in which word lines (14), which are in each case electrically connected to gate electrodes (13) arranged along the respective second trench (7), are produced in the second trenches (7),
- in which a third insulation structure (15) is produced in the second trenches (7),
- in which the capacitor dielectric (16) is produced in such a manner that it covers at least the surface of the pillars in the area of the main surface (1),
- in which the capacitor plate (17) is produced in such a manner that it covers at least the pillars.

8. Method according to Claim 7,
- in which the first insulation structures (6) and the third insulation structures (15) are formed in such a way that they end at the same level as the pillars,
- in which, in an etching process which is selective with respect to the pillars, the first insulation structures (6) and the third insulation structures (15) are etched back, steps, which are covered by the capacitor dielectric (16) being formed on the flanks of the pillars.

9. Method according to one of Claims 7 or 8,
- in which the first trenches (4) and the second trenches (7) are formed with substantially the same width, the distance between adjacent trenches (4, 7) being substantially equal to the width of the trenches,
- in which the holes (11) are etched using a mask (9) with substantially square mask openings (10), the side length of the square mask openings (10) being substantially equal to the width of the trenches (4, 7),
- in which the centre points of the square mask openings (10) are arranged offset with respect to the centres of the first trenches (4) and of the second trenches (7) by less than one width of the trenches (4, 7).

10. Method according to one of Claims 7 to 9,
- in which a substrate which, at least in the area of the DRAM cell arrangement, comprises monocrystalline silicon, is used as semiconductor substrate (2),
- in which the insulation structures (6, 8, 15) are formed from SiO₂,
- in which the bit lines and the region (3) which has been doped with the second conductivity type are formed by implantation,
- in which the word lines (14) and the gate electrodes (13) are formed from doped polysilicon.

## Revendications

1. Structure de cellule DRAM avec des cellules de mémoire, qui comprend respectivement un transistor de lecture et un condensateur de puissance, qui comprend ce qui suit :
- un substrat semi-conducteur (2), qui est dopé au moins dans la zone de la structure de cellule DRAM par un premier type de conductivité, le substrat semi-conducteur (2) comprenant des colonnes agencées en rangées et en intervalles, qui sont adjacentes à une surface principale (1) du substrat semi-conducteur (2) et sont formées par une première et une deuxième tranchée (4, 7);
- dans laquelle chaque colonne présente une zone (2) dopée par un deuxième type de conductivité opposé au premier et une zone (2) dopée par le premier type de conductivité, la zone (3) dopée par le deuxième type de conductivité est respectivement adjacente à la surface principale (1) et, dans la zone de la surface principale (1), aux flancs de la colonne respective, la zone (2) dopée par le premier type de conductivité est agencée en dessous de la zone (3) dopée par le deuxième type de conductivité, adjacente aux flancs de la colonne et en connexion avec la zone du substrat semi-conducteur (2) dopée par le premier type de conductivité;
- des lignes de bits noyées (5), qui sont agencées sur les fonds des premières tranchées (4) et s'étendent sensiblement parallèlement l'une à l'autre;
- dans laquelle les transistors de lecture sont conformés en transistors MOS verticaux intégrés aux colonnes, dont une zone de source/drain est la zone (3) dopée par le deuxième type de conductivité et dont l'autre zone de source/drain (5) est respectivement une ligne de bits noyée (5), dont l'électrode de grille (13) est agencée respectivement sur une paroi de colonne au-dessus d'un oxyde de grille (12);
- des lignes de mots noyées (14), qui sont agencées dans les deuxièmes tranchées (7) et s'étendent sensiblement parallèlement l'une à l'autre, qui croisent de manière isolée les lignes de bits et sont isolées par rapport aux colonnes, les électrodes de grille (13) étant raccordées respectivement à l'une des lignes de mots (14); et
- dans laquelle les condensateurs de puissance sont constitués respectivement d'une des zones (3) adjacentes à la surface principale (1) et dopées par le deuxième type de conductivité comme noeuds de mémoire, d'un diélectrique de condensateur (16) agencé par-dessus et d'une plaque de condensateur (17) encore agencée par-dessus.

2. Structure de cellule DRAM selon la revendication 1, dans laquelle le diélectrique de condensateur (16) est formé d'un matériau ayant une constante diélectrique relative εᵣ entre 100 et 1000.

3. Structure de cellule DRAM selon l'une quelconque des revendications 1 ou 2, dans laquelle le diélectrique de condensateur (16) se présente sous la forme d'une couche à surface plane.

4. Structure de cellule DRAM selon l'une quelconque des revendications 1 à 3, dans laquelle il est prévu des structures isolantes (6, 15) qui ne comblent que partiellement la zone comprise entre des colonnes voisines de telle sorte que les flancs des colonnes soient revêtus partiellement de diélectrique de condensateur (16) dans la zone de la surface principale (1).

5. Structure de cellule DRAM selon l'une quelconque des revendications 1 à 4, dans laquelle la largeur des lignes de bits (5) et des lignes de mots (14) ainsi que la distance entre des lignes de bits voisines (5) et entre des lignes de mots voisines (14) sont respectivement sensiblement égales, et dans laquelle l'oxyde de grille (12) des transistors MOS verticaux recouvre en partie respectivement deux flancs adjacents d'une colonne de telle sorte qu'il isole la ligne de mots respective (14) par rapport à la colonne.

6. Structure de cellule DRAM selon l'une quelconque des revendications 1 à 5
- dans laquelle le substrat semi-conducteur (2) comprend du silicium monocristallin au moins dans la zone de la structure de cellule DRAM,
- dans laquelle les structures isolantes comprennent du SiO₂,
- dans laquelle les lignes de bits (5) se présentent sous la forme de zones dopées dans le substrat semi-conducteur (2), et
- dans laquelle les électrodes de grille (13) et les lignes de mots (14) comprennent du polysilicium dopé.

7. Procédé de fabrication d'une structure de cellule DRAM selon la revendication 1,
- dans lequel, dans le substrat semi-conducteur (2), qui est dopé au moins dans une zone pour la structure de cellule DRAM par un premier type de conductivité, on forme à l'intérieur de cette zone une zone (3) dopée par un deuxième type de conductivité opposé au premier, qui est adjacente à une surface principale (1) du substrat semi-conducteur (2),
- dans lequel, dans le substrat semi-conducteur (2), on forme les premières tranchées (4) qui s'étendent sensiblement de manière parallèle les unes aux autres,
- dans lequel les lignes de bits (5) sont formées sur le fond des premières tranchées (4),
- dans lequel, ensuite, les premières tranchées (4) sont comblées d'une première structure isolante (6),
- dans lequel, ensuite, on forme les secondes tranchées (7) qui croisent les premières tranchées (4) et qui atteignent au moins la surface supérieure de la ligne de bits (5), formant ainsi les colonnes,
- dans lequel les secondes tranchées (7) sont comblées par une seconde structure isolante (8), dont la hauteur est plus faible que la profondeur des secondes tranchées (7),
- dans lequel on effectue une gravure anisotrope qui attaque la première structure isolante (6) et la seconde structure isolante (8) sélectivement par rapport aux colonnes du matériau semi-conducteur et dans lequel sont gravés des orifices (11), qui s'étendent de la surface principale (1) jusqu'à la hauteur des lignes de bits (5) et dans lesquels respectivement un flanc des colonnes, qui est adjacent à l'une des secondes tranchées (7), est dégagé partiellement,
- dans lequel des oxydes de grille (12) sont formés sur les flancs dégagés des colonnes,
- dans lequel, dans les orifices (11), sont formées les électrodes de grille (13) qui comblent respectivement en largeur les orifices (11),
- dans lequel, dans les secondes tranchées (7), sont formées des lignes de mots (14), qui sont connectées par voie électrique respectivement à des électrodes de grille (13) agencées le long des secondes tranchées respectives (7),
- dans lequel, dans les secondes tranchées (7), est formée une troisième structure isolante (15),
- dans lequel ledit diélectrique de condensateur (16) est formé de manière qu'il recouvre au moins la surface des colonnes dans la zone de la surface principale (1), et
- dans lequel la plaque de condensateur (17) est formée de manière qu'elle recouvre au moins les colonnes.

8. Procédé selon la revendication 7,
- dans lequel les premières structures isolantes (6) et les troisièmes structures isolantes (15) sont formées de manière qu'elles se situent à hauteur des colonnes, et
- dans lequel, au cours d'un procédé de gravure, on re-grave de manière sélective par rapport aux colonnes les premières structures isolantes (6) et les troisièmes structures isolantes (15), en formant sur les flancs des colonnes des gradins qui sont recouverts par le diélectrique de condensateur (16).

9. Procédé selon l'une quelconque des revendications 7 ou 8,
- dans lequel les premières tranchées (4) et les secondes tranchées (7) sont formées sensiblement avec la même largeur, l'écartement entre tranchées voisines (4, 7) étant sensiblement égal à la largeur des tranchées,
- dans lequel les orifices (11) sont gravés en utilisant un masque (9) avec des ouvertures de masque sensiblement carrées (10), la longueur latérale des ouvertures carrées (10) du masque étant sensiblement égale à la largeur des tranchées (4, 7), et
- dans lequel les points centraux des ouvertures carrées (10) du masque soient agencées décalées par rapport aux centres des premières tranchées (4) ainsi que des secondes tranchées (7) de moins d'une largeur des tranchées (4, 7).

10. Procédé selon l'une quelconque des revendications 7 à 9,
- dans lequel on utilise comme substrat semi-conducteur (2) un substrat qui comprend du silicium monocristallin au moins dans la zone de la structure de cellule DRAM,
- dans lequel les structures isolantes (6, 8, 15) sont formées de SiO₂,
- dans lequel les lignes de bits et la zone (3) dopée par le deuxième type de conductivité sont formées par implantation, et
- dans lequel les lignes de mots (14) et les électrodes de grille (13) sont formées de polysilicium dopé.
